# EUROPÄISCHE PATENTANMELDUNG

(11) **EP 1 178 531 A1**
(43) Veröffentlichungstag der Anmeldung: **06.02.2002**
(21) Anmeldenummer: 01000346.5
(22) Anmeldetag: 03.08.2001
(51) Int. Cl.: H01L 27/02, H03K 19/003

(54) **schaltungsanordnung**

(30) Priorität: 05.08.2000 DE 10038323
(71) Anmelder: Philips Corporate Intellectual Property GmbH, 52064 Aachen (DE); Koninklijke Philips Electronics N.V., 5621 BA Eindhoven (NL)
(72) Erfinder: Muth, Michael c/o Philips Corporate Intellectual, 52064 Aachen (DE)
(74) Vertreter: Volmer, Georg, Dipl.-Ing.

(57) **Zusammenfassung**

Um eine Schaltungsanordnung zum Schutz des Eingangs einer insbesondere für Analogsignale ausgelegten integrierten Schaltung, insbesondere einer CMOS-Schaltung, vor Überspannungen, welche Schaltungsanordnung (100) aufweist:
- mindestens zwei Eingangsanschlüsse (10; 20) und
- mindestens eine Schutzstufe (S), bei der jeder der Eingangsanschlüsse (10; 20) durch jeweils eine Schutzdiode (12; 22), insbesondere Halbleiterdiode, mit einer Versorgungsspannung (U_{S}) und durch jeweils eine Schutzdiode (16; 26), insbesondere Halbleiterdiode, mit einem Referenzpotential (U_{R}) verbunden ist,
zu schaffen, durch die bei einfacher sowie kostengünstiger Struktur zwar einerseits störende und den Signalpfad beeinträchtigende Demodulationseffekte am Eingangssignal zuverlässig vermieden werden können, bei der jedoch andererseits ein wirksamer Schutz vor etwa durch elektrostatische Entladungen verursachten Überspannungen weiterhin besteht, wird vorgeschlagen,
- dass zu jeder der Schutzdioden (12, 16; 22, 26) mindestens eine weitere Diode (14, 18; 24, 28) in Reihe geschaltet ist und
- dass der Schutzstufe (S) mindestens eine Filterstufe (F), insbesondere mindestens eine Hochfrequenzfilterstufe, nachgeschaltet ist.

## Beschreibung

Die Erfindung betrifft eine Schaltungsanordnung zum Schutz des Eingangs einer insbesondere für Analogsignale ausgelegten integrierten Schaltung, insbesondere einer CMOS-Schaltung, vor Überspannungen, welche Schaltungsanordnung aufweist:
- mindestens zwei Eingangsanschlüsse und
- mindestens eine Schutzstufe, bei der jeder der Eingangsanschlüsse durch jeweils eine Schutzdiode, insbesondere Halbleiterdiode, mit einer Versorgungsspannung und durch jeweils eine Schutzdiode, insbesondere Halbleiterdiode, mit einem Referenzpotential verbunden ist.

Eine solche Schaltungsanordnung ist etwa durch die Druckschrift US 4 254 442 bekannt. Dort ist eine Schaltungsanordnung zum Schützen von Fernsprechleitungen und von mit diesen verbundenen elektronischen Schaltkreisen vor Überspannungen offenbart; ein erstes Paar Halbleiter-Schutzdioden ist gleichsinnig zwischen zwei Punkten konstanten Potentials derart in Reihe geschaltet, dass die Schutzdioden normalerweise gesperrt sind, wobei der Verbindungspunkt zwischen den Schutzdioden mit einer Ader der Fernsprechleitung verbunden ist, wodurch im Falle des Auftretens von Überspannungen die Spannung der Ader auf das Potential des einen oder des anderen Punktes konstanten Potentials geklemmt wird; des weiteren ist ein zweites Paar Halbleiter-Schutzdioden vorgesehen, das gleichsinnig zwischen zwei Punkten konstanten Potentials derart in Reihe geschaltet ist, dass die Schutzdioden normalerweise gesperrt sind, wobei der Verbindungspunkt zwischen den Schutzdioden mit der Ader der Fernsprechleitung verbunden ist; in der Ader der Fernsprechleitung ist zwischen dem Verbindungspunkt mit dem ersten Schutzdiodenpaar und dem Verbindungspunkt mit dem zweiten Schutzdiodenpaar eine Impedanz, vorzugsweise eine Induktivität, geschaltet, wobei der Potentialbereich zwischen den Punkten konstanten Potentials des zweiten Schutzdiodenpaars größer als der Potentialbereich zwischen den Punkten konstanten Potentials des ersten Schutzdiodenpaars ist bzw. diesem Potentialbereich entspricht.
Die bekannten Schaltungsanordnungen ermöglichen einen Schutz vor Überspannungen, wie sie beispielsweise an den sogenannten Bondpads (= elektrisch leitende Kontaktgebiete einer integrierten Schaltung, insbesondere eines Chips) auftreten und die nachgeschaltete integrierte Schaltung zerstören können (derartige Überspannungen können beispielsweise im Falle von ESD (= electrostatic discharge = elektrostatische Entladung) auftreten; insbesondere CMOS-Schaltungen sind aufgrund ihres Aufbaus gegenüber zu hohen Eingangsspannungen sehr empfindlich). Hierbei werden die Schutzdioden leitend, wenn die Eingangsspannung unter das Referenzpotential absinkt oder die Versorgungsspannung übersteigt, so dass Überspannungen über die Schutzdioden abgeleitet, das heißt durch die Schutzdioden gewissermaßen kurzgeschlossen werden.

Dies bedeutet mit anderen Worten, dass der Aussteuerungsbereich für die Eingangsspannung auf den Spannungsbereich zwischen dem Referenzpotential und der Versorgungsspannung limitiert ist. Eine derartige Begrenzung des Aussteuerungsbereichs für die Eingangsspannung ist jedoch dann problematisch, wenn von außen eingestrahlte hochfrequente Störungen zu Spannungsamplituden an den Eingangsanschlüssen führen, die außerhalb des durch das Referenzpotential und durch die Versorgungsspannung definierten Aussteuerungsbereichs liegen. In diesem Falle schalten die Schutzdioden in Durchlaßrichtung, was Demodulationen des zumeist analogen Eingangssignals nach sich zieht; derartige Demodulationseffekte führen gerade auch im unteren Frequenzbereich zu signifikanten Störungen im Signalpfad

Der Erfindung liegt die Aufgabe zugrunde, eine Schaltungsanordnung der eingangs genannten Art bereitzustellen, durch die bei einfacher sowie kostengünstiger Struktur zwar einerseits störende und den Signalpfad beeinträchtigende Demodulationseffekte am Eingangssignal zuverlässig vermieden werden, bei der jedoch andererseits ein wirksamer Schutz vor etwa durch elektrostatische Entladungen verursachten Überspannungen besteht.

Diese Aufgabe wird durch die im Anspruch 1 angegebenen Merkmale gelöst. Vorteilhafte Ausgestaltungen und zweckmäßige Weiterbildungen der vorliegenden Erfindung sind in den Unteransprüchen gekennzeichnet.
Gemäß der Lehre der vorliegenden Erfindung kann dadurch, dass zu jeder der Schutzdioden mindestens eine weitere Diode, insbesondere mindestens eine Z(ener)-Diode und/oder mindestens eine vorzugsweise parasitäre Transistordiode mit Z(ener)-Effekt, in Reihe geschaltet ist, der Aussteuerungsbereich für die Eingangsspannung auf einen Spannungsbereich erweitert werden, der um die Durchbruchspannungen der Z(ener)- Dioden vergrößert und mithin größer als der Spannungsbereich zwischen dem Referenzpotential und der Versorgungsspannung ist.

Hierbei sind die weiteren Dioden insoweit gezielt zu dimensionieren, als der um die Durchbruchspannungen der Z(ener)-Dioden erweiterte Spannungsbereich innerhalb des Spannungsbereichs zu liegen hat, außerhalb dessen es zu einer Schädigung oder sogar zu einer Zerstörung der zu schützenden integrierten Schaltung kommt. Weiterhin sollte die weitere Diode in bevorzugter Weise niederohmig sein, das heißt einen niedrigen Widerstandswert aufweisen, um den kurzzeitigen, durch die Überspannung hervorgerufenen Stromfluß (sogenannter ESD-Stromfluß) aufnehmen zu können.

Durch die Anordnung der mindestens einen weiteren Diode in Reihe zur Schutzdiode kann der integrierten Schaltung (beispielsweise CMOS-Schaltung) auf überraschende Weise eine höhere Eingangsspannung, insbesondere eine größere Wechselspannungsamplitude, zugeführt werden, ohne dass die nachgeschaltete integrierte Schaltung Schaden nimmt. Diese Eingangsspannung, insbesondere die Wechselspannungsamplitude, kann das Referenzpotential um die Durchbruchspannung der weiteren Diode(n) unterschreiten bzw. die Versorgungsspannung um die Durchbruchspannung der weiteren Diode(n) überschreiten, ohne dass die Schutzdioden leitend werden und ohne dass ein unerwünschter, durch die (Schutz-)Dioden herbeigeführter Demodulationseffekt auftritt.

Nun ist es zwar aus der Druckschrift EP 0 360 933 A1 bekannt, zwei Durchbruchdioden in Serie zu schalten oder eine Durchbruchdiode und eine Z(ener)-Diode in Serie zu schalten. Jedoch befaßt sich die Druckschrift EP 0 360 933 A1 nicht mit dem Problem, wie mit den von außen eingestrahlten hochfrequenten Störungen nach Durchlaufen der Schutzstufe umzugehen ist, die zu erhöhten Spannungsamplituden an den Eingangsanschlüssen führen und die aufgrund des erfindungsgemäß erweiterten Aussteuerungsbereich für die Eingangsspannung erst bei entsprechend hohen Störamplituden den Signalpfad beeinträchtigende Demodulationseffekte nach sich ziehen.

Hierzu ist der Schutzstufe gemäß der Lehre der vorliegsnden Erfindung mindestens eine Filtersfufe, insbesondere mindestens eine Hochfrequenzfilterstufe, nachgeschaltet. Durch diese Filterstufe werden nicht demodulierte hochfrequente Störsignale mit Nachdruck gedämpft, so dass die integrierte Schaltung von diesen Störsignalen weitgehend unbeeinträchtigt bleibt.

In diesem Zusammenhang wird der Fachmann insbesondere zu schätzen wissen, dass ein Nachschalten einer derartigen (Hochfrequenz-)Filterstufe hinter eine konventionelle Eingangsstufe der eingangs genannten Art (vgl. etwa die Druckschrift US 4 254 442) ein bei dieser Anordnung häufig auftretendes demoduliertes, mithin niederfrequentes Signal insoweit nicht herausfiltern könnte, als sich dieses demodulierte Signal gerade in etwa im (Nieder-)Frequenzbereich des Nutzsignals bewegen würde. Im Gegensatz dazu behält die der Schutzstufe nachgeschaltete (Hochfrequenz-)Filterstufe gemäß der Lehre der vorliegenden Erfindung aufgrund des buchstäblich "erweiterten" ESD-Schutzes ihre volle Wirksamkeit.

Die Erfindung betrifft auch eine integrierte Schaltung, insbesondere CMOS-Schaltung, aufweisend mindestens eine Schaltungsanordnung der vorstehend beschriebenen Art.

Ein Ausführungsbeispiel der vorliegenden Erfindung wird nachstehend anhand der Zeichnung näher erläutert. Es zeigt:

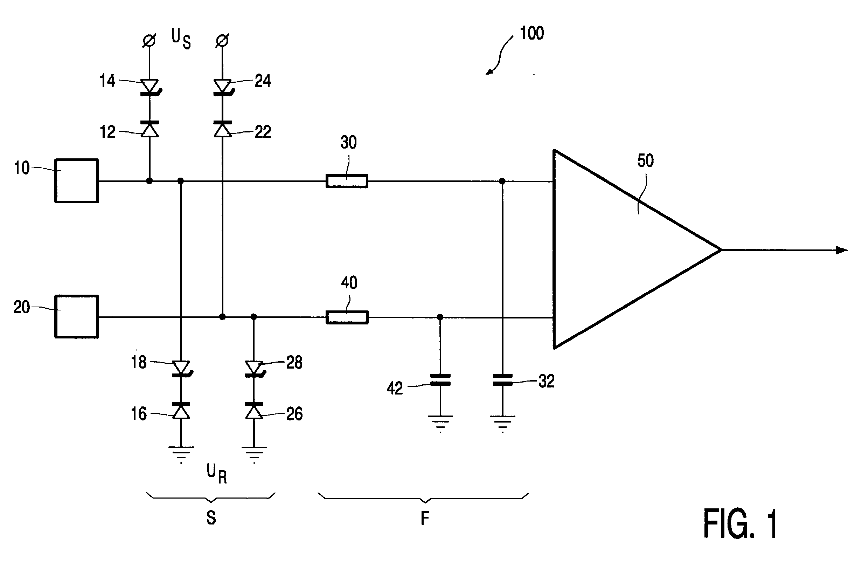

Fig. 1 ein Ausführungsbeispiel einer Schaltungsanordnung gemäß der vorliegenden Erfindung in schematischer Prinzipdarstellung; und

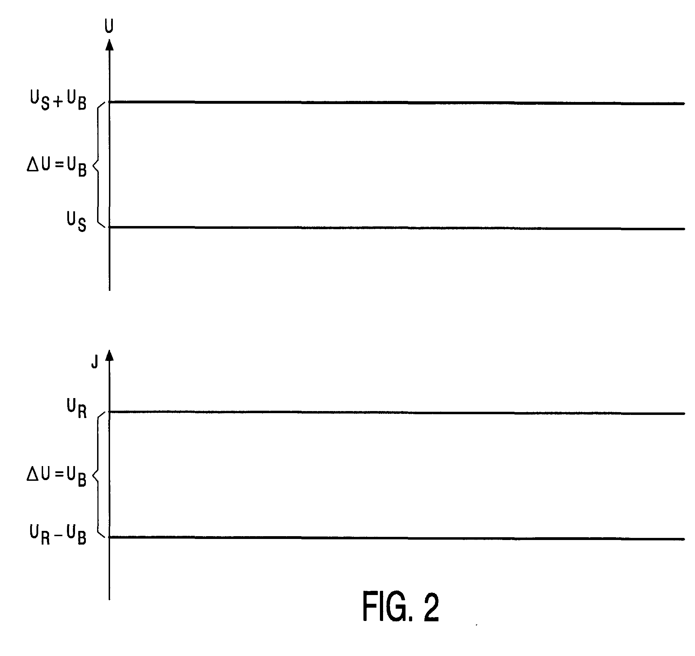

Fig. 2 den Aussteuerungsbereich für die Eingangsspannung bei der Schaltungsanordnung gemäß Fig. 1 im Vergleich zu einer Schaltungsanordnung gemäß dem Stand der Technik. Die Schaltungsanordnung 100 ist zum Schutz des Eingangs, und hierbei im speziellen der sogenannten Bondpads (= elektrisch leitende Kontaktgebiete einer integrierten Schaltung, insbesondere eines Chips), einer für Analogsignale ausgelegten integrierten CMOS-Schaltung (in Figur 1 aus Gründen der Übersichtlichkeit nicht dargestellt; vgl. den Pfeil im rechten Teil von Figur 1) vor Überspannungen vorgesehen und weist zwei Eingangsanschlüsse 10, 20 auf.

An diese Eingangsanschlüsse 10, 20 schließt sich eine Schutzstufe S an; hierbei ist der Eingangsanschluß 10 durch eine Halbleiter-Schutzdiode 12 mit einer Versorgungsspannung U_{S} (vgl. auch Figur 2) und durch eine Halbleiter-Schutzdiode 16 mit einem dem Erdpotential entsprechenden Referenzpotential U_{R} (vgl. auch Figur 2) verbunden. Zu den Halbleiter-Schutzdioden 12 bzw. 16 ist jeweils eine weitere Diode 14 bzw. 18, nämlich jeweils eine Z(ener)-Diode, in Serie geschaltet (anstelle der Z(ener)-Diode 14 bzw. 18 könnte zu jeder der Schutzdioden 12 bzw. 16 auch mehr als eine weitere Diode in Reihe geschaltet sein).

In gleicher Weise ist der Eingangsanschluß 20 durch eine Halbleiter-Schutzdiode 22 mit einer Versorgungsspannung U_{S} und durch eine Halbleiter-Schutzdiode 26 mit einem dem Erdpotential entsprechenden Referenzpotential U_{R} verbunden. Zu den Halbleiter-Schutzdioden 22 bzw. 26 ist jeweils eine weitere Diode 24 bzw. 28, nämlich jevseils eine Z(ener)-Diode, in Serie geschaltet (anstelle der Z(ener)-Diode 24 bzw. 28 könnte zu jeder der Schutzdioden 22 bzw. 26 auch mehr als eine weitere Diode in Reihe geschaltet sein).

Wie aus Figur 2 hervorgeht, kann durch die Anordnung der weiteren Dioden 14 und 18 sowie 24 und 28 der durch die Schutzdioden 12 und 16 sowie 22 und 26 vorgegebene Aussteuerungsbereich U_{R} < U < U_{S} für die Eingangsspannung auf einen Spannungsbereich U_{R}-U_{B} < U < U_{S}+U_{B} erweitert werden, der um die jeweilige Durchbruchspannung ΔU_{B} der Z(ener)-Dioden 14 bzw. 18 sowie 24 bzw. 28 vergrößert und mithin größer als der Spannungsbereich U_{R} < U < U_{S} zwischen dem Referenzpotential U_{R} und der Versorgungsspannung U_{S} ist.
Durch die Anordnung der weiteren Dioden 14 und 18 sowie 24 und 28 in Reihe zu den Schutzdioden 12 und 16 sowie 14 und 18 kann der integrierten Schaltung (CMOS-Schaltung) eine größere Wechselspannungsamplitude zugeführt werden, ohne dass die nachgeschaltete integrierte Schaltung Schaden nimmt. Diese Wechselspannungsamplitude kann das Referenzpotential U_{R} um die Durchbruchspannung ΔU_{B} der weiteren Dioden 18 sowie 28 unterschreiten bzw. die Versorgungsspannung U_{S} um die Durchbruchspannung ΔU_{B} der weiteren Dioden 14 sowie 24 überschreiten, ohne dass die Schutzdioden 12 und 16 sowie 14 und 18 leitend werden und ohne dass ein unerwünschter, durch die (Schutz-) Dioden herbeigeführter Demodulationseffekt auftritt.

Wie des weiteren Figur 1 entnehmbar ist, ist der Schutzstufe S eine Hochfrequenzfilterstufe F nachgeschaltet, bei der jedem der Eingangsanschlüsse 10 bzw. 20 jeweils ein RC-Glied 30, 32 (aufweisend einen Widerstand 30 und einen Kondensator 32) bzw. 40, 42 (aufweisend einen Widerstand 40 und einen Kondensator 42) nachgeschaltet ist. Durch diese Hochfrequenzfilterstufe F werden nicht demodulierte hochfrequente Störsignale gedämpft, so dass die sich anschließende integrierte Schaltung von diesen Störsgnalen weitgehend unbeeinträchtigt bleibt, denn die Hochfrequenzfilterstufe F entfaltet aufgrund des "erweiterten" ESD-Schutzes (Spannungsbereich U_{R}-U_{B} < U < U_{S}+U_{B} für das Eingangssignal) ihre volle Wirksamkeit.

Der Hochfrequenzfilterstufe F nachgeschaltet und der zu schützenden integrierten Schaltung vorgeschaltet ist schließlich eine Vorverstärkereinheit 50.

Die anhand der Figuren 1 und 2 vemstaulichte Schaltungsanordnung weist im Vergleich zu konventionellen Schaltungsanordnungen (vgl. etwa die Druckschrift US 4 254 442) eine signifikant verbesserte elektromagnetische Verträglichkeit (EMV) auf, denn durch die Anordnung der weiteren Dioden 14 und 18 sowie 24 und 28 in Reihe zu den Schutzdioden 12 und 16 sowie 14 und 18 werden externe hochfrequente Störsignale aufgrund der erhöhten Demodulationsspannung erst bei entsprechend höheren Störamplituden demoduliert; die nicht demodulierten hochfrequenten Störagnale werden durch die der Schutzstufe S nachgeschaltete Hochfrequenzfilterstufe F erfolgreich gedämpft.

### Bezugszeichenliste

- 100: Schaltungsanordnung
- 10: (erster) Eingangsanschluß
- 12: (erste) Schutzdiode, mit Versorgungsspannung U_{S} verbunden
- 14: weitere Diode, zu Schutzdiode 12 in Reihe geschaltet
- 16: (erste) Schutzdiode, mit Referenzpotential U_{R} verbunden
- 18: weitere Diode, zu Schutzdiode 16 in Reihe geschaltet
- 20: (zweiter) Eingangsanschluß
- 22: (zweite) Schutzdiode, mit Versorgungsspannung U_{S} verbunden
- 24: weitere Diode, zu Schutzdiode 22 in Reihe geschaltet
- 26: (zweite) Schutzdiode, mit Referenzpotential U_{R} verbunden
- 28: weitere Diode, zu Schutzdiode 26 in Reihe geschaltet
- 30, 32: (erstes) RC-Glied der Filterstufe F, aufweisend
30 (erster) Widerstand
32 (erster) Kondensator
- 40, 42: (zweites) RC-Glied der Filterstufe F, aufweisend
40 (zweiter) Widerstand
42 (zweiter) Kondensator
- 50: Vorverstärkereinheit
- F: Filterstufe, insbesondere Hochfrequenzfilterstufe
- S: Schutzstufe
- U_{B}: Durchbruchspannung der weiteren Dioden 14,18; 24, 28
- U_{R}: Referenzpotential
- U_{S}: Versorgungsspannung

## Patentansprüche

1. Schaltungsanordnung zum Schutz des Eingangs einer insbesondere für Analogsignale ausgelegten integrierten Schaltung, insbesondere einer CMOS-Schaltung, vor Überspannungen, welche Schaltungsanordnung (100) aufweist:
- mindestens zwei Eingangsanschlüsse (10; 20) und
- mindestens eine Schutzstufe (S), bei der jeder der Eingangsanschlüsse (10; 20) durch jeweils eine Schutzdiode (12; 22), insbesondere Halbleiterdiode, mit einer Versorgungsspannung (U_{S}) und durch jeweils eine Schutzdiode (16; 26), insbesondere Halbleiterdiode, mit einem Referenzpotential (U_{R}) verbunden ist,
**dadurch gekennzeichnet,**
**dass** zu jeder der Schutzdioden (12, 16; 22, 26) mindestens eine weitere Diode (14, 18; 24, 28) in Reihe geschaltet ist und
- **dass** der Schutzstufe (S) mindestens eine Filtecstufe (F), insbesondere mindestens eine Hochfrequenzfilterstufe, nachgeschaltet ist.

2. Schaltungsanordnung gemäß Anspruch 1,
**dadurch gekennzeichnet,**
**dass** die weitere Diode (14, 18; 24, 28)
- mindestens eine Z(ener)-Diode und/oder
- mindestens eine vorzugsweise parasitäre Transistordiode mit Z(ener)-Effekt ist.

3. Schaltungsanordnung gemäß Anspruch 1 oder 2,
**dadurch gekennzeichnet,**
**dass** zu jeder der Schutzdioden (12, 16; 22, 26) mehr als eine weitere Diode (14,18; 24, 28) in Reihe geschaltet ist.

4. Schaltungsanordnung gemäß mindestens einem der Ansprüche 1 bis 3,
**dadurch gekennzeichnet,**
**dass** die weitere Diode (14, 18; 24, 28) eine niedrige Durchbruchspannung aufweist.

5. Schaltungsanordnung gemäß mindestens einem der Ansprüche 1 bis 4,
**dadurch gekennzeichnet,**
**dass** die weitere Diode (14, 18; 24, 28) einen niedrigen Widerstandswert aufweist.

6. Schaltungsanordnung gemäß mindestens einem der Ansprüche 1 bis 5,
**dadurch gekennzeichnet,**
**dass** die Filterstufe (F) mindestens zwei RC-Glieder (30, 32; 40, 42) aufweist.

7. Schaltungsanordnung gemäß Anspruch 6,
**dadurch gekennzeichnet,**
**dass** jedem der Eingangsanschlüsse (10; 20) jeweils ein RC-Glied (30, 32; 40, 42) nachgeschaltet ist.

8. Schaltungsanordnung gemäß mindestens einem der Ansprüche 1 bis 7,
**dadurch gekennzeichnet,**
**dass** der Filterstufe (F) mindestens eine Vorverstärkereinheit (50) nachgeschaltet ist.

9. Schaltungsanordnung gemäß mindestens einem der Ansprüche 1 bis 8,
**dadurch gekennzeichnet,**
**dass** das Referenzpotential (U_{R}) das Erdpotential oder das Massepotential ist.

10. Integrierte Schaltung insbesondere CMOS-Schaltung, aufweisend mindestens eine Schaltungsanordnung (100) gemäß mindestens einem der Ansprüche 1 bis 9.
